# EUROPÄISCHE PATENTSCHRIFT

(11) **EP 1 338 038 B1**
(45) Veröffentlichungstag und Bekanntmachung des Hinweises auf die Patenterteilung: **27.03.2013**
(21) Anmeldenummer: 01999011.8
(22) Anmeldetag: 30.11.2001
(51) Int. Cl.: H01L 51/05, H01L 29/04

(54) **ELEKTRONISCHES BAUELEMENT MIT HALBLEITENDEN SCHICHTEN, ELEKTRONISCHE SCHALTUNG, SOWIE VERFAHREN ZUR HERSTELLUNG**
ELECTRONIC COMPONENT WITH SEMICONDUCTOR LAYERS, ELECTRONIC CIRCUIT AND METHODS FOR PRODUCTION THEREOF
COMPOSANT ELECTRONIQUE DOTE DE COUCHES SEMI-CONDUCTRICES, CIRCUIT ELECTRONIQUE, ET PROCEDES DE FABRICATION ASSOCIES

(30) Priorität: 30.11.2000 DE 10059498
(43) Veröffentlichungstag der Anmeldung: 27.08.2003
(73) Patentinhaber: Qimonda AG, 81739 München (DE)
(72) Erfinder: SCHMID, Günter, 91334 Hemhofen (DE)
(74) Vertreter: Viering, Jentschura & Partner
(86) Internationale Anmeldenummer: PCT/DE2001/004511
(87) Internationale Veröffentlichungsnummer: WO 2002/045183

(56) Entgegenhaltungen:
- EP-A- 0 528 662
- WO-A-00/20916
- WO-A1-00/33396
- US-A- 4 947 219
- US-A- 5 672 214
- US-A- 5 868 869
- KUCZKOWSKI A: "THE PROSPECTS FOR POLYESTER POLYMER-CDS POWER COMPOSITES IN PHOTOELECTRONIC DEVICE APPLICATIONS" JOURNAL OF PHYSICS D. APPLIED PHYSICS, IOP PUBLISHING, BRISTOL, GB, Bd. 22, Nr. 11, 14. November 1989 (1989-11-14), Seiten 1731-1735, XP000072966 ISSN: 0022-3727
- TRINDADE T ET AL: "Preparation and optical properties of CdSe/polymer nanocomposites" SCRIPTA MATERIALIA, ELSEVIER, NEW YORK, NY, US, Bd. 43, Nr. 6, 28. August 2000 (2000-08-28), Seiten 567-571, XP004326207 ISSN: 1359-6462
- GINGER D S ET AL: "CHARGE SEPARATION IN CONJUGATED-POLYMER/NANOCRYSTAL BLENDS" SYNTHETIC METALS, ELSEVIER SEQUOIA, LAUSANNE, CH, Bd. 101, Nr. 1/3, 1999, Seiten 425-428, XP000879469 ISSN: 0379-6779
- GREENHAM N C ET AL: "CHARGE SEPARATION AND TRANSPORT IN CONJUGATED POLYMER/CADMIUM SELENIDE NANOCRYSTAL COMPOSITES STUDIED BY PHOTOLUMINESCENCE QUENCHING AND PHOTOCONDUCTIVITY" SYNTHETIC METALS, ELSEVIER SEQUOIA, LAUSANNE, CH, Bd. 84, Nr. 1/3, 1997, Seiten 545-546, XP002060965 ISSN: 0379-6779
- BARATON M-I ET AL: "DRIFTS characterization of a nanostructured gallium nitride powder and its interactions with organic molecules" MATERIALS SCIENCE AND ENGINEERING B, ELSEVIER SEQUOIA, LAUSANNE, CH, Bd. 50, Nr. 1-3, 18. Dezember 1997 (1997-12-18), Seiten 42-45, XP004119103 ISSN: 0921-5107

## Beschreibung

Die vorliegende Erfindung betrifft ein elektronisches Bauelement mit halbleitenden Schichten, eine elektronische Schaltung mit mindestens einem solchem elektronischen Bauelement, sowie Verfahren zur Herstellung eines elektronischen Bauelements mit halbleitenden Schichten.

Die halbleitenden (aktiven) Bauelemente von Mikrochips bestehen üblicherweise aus perfekten Einkristallen hochreiner halbleitender anorganischer Substrate/Materialien wie Silizium oder Germanium. Die Funktionalität dieser Bauelemente beruht auf den elektrischen Grenzflächeneigenschaften zwischen unterschiedlich halbleitenden Schichten oder Domänen, die durch n- bzw. p-Dotierung der Substrate erzeugt werden. Diese gezielte Dotierung erfordert allerdings aufwendige lithographische Maskierungs,- Ätz,- und Ionenimplantationsprozesse, einschließlich der Strukturierung der Substrate mit Hilfe von Photolacken. So hergestellte Bauelemente kommen jedoch aufgrund der aufwendigen Herstellungsverfahren nicht für Anwendungen in Betracht, bei denen der Preis der Bauelemente vorrangig ist.

Eine Möglichkeit zur Herstellung von halbleitenden Substraten und darauf basierenden Bauelementen, die ohne aufwendige Dotierungsmaßnahmen bei der Halbleiterherstellung auskommen kann, besteht in der Verwendung von halbleitenden organischen Polymeren wie Polyvinylcarbazole, Polythiophene, Polyaniline, Poly-p-phenylene und Poly-para-phenylvinylidene (PPV) und dergleichen. Substrate auf Basis solcher halbleitenden organischer Polymere können, wie in den PCT-Anmeldungen WO 99/39373 oder WO 99/19900 beschrieben, hergestellt werden, indem als n- bzw. p-Leiter einsetzbare halbleitende organische Polymere in einem organischen Lösungsmittel gelöst werden und diese Gemische mittels herkömmlicher Tintenstrahldruck-Technologie schichtweise auf ein Substrat aufgedruckt werden. Nachteilig bei der Verwendung derartiger organischer Polymere ist allerdings unter anderem ihre geringe Leitfähigkeit bzw. Mobilität der Ladungsträger, ihre vergleichsweise teure Herstellung, sowie die geringe Stabilität dotierter Materialien gegenüber Umwelteinflüssen. Daher eignen sie sich insbesondere nicht für Niedrigpreisanwendungen von halbleitenden Bauelementen und/oder Schaltkreisen.

Ferner ist aus den deutschen Offenlegungsschriften DE 198 54 938 und DE 199 05 694 ein Bauelement mit einer ersten Schicht, einer zweiten Schicht und einer dazwischen befindliche Zwischenschicht bekannt, wobei in der Zwischenschicht ein erstes und/oder ein zweites Material enthalten ist sowie ferner mindestens eine Substanz, die eine andere Leitfähigkeit als das erste und/oder zweite Material aufweist, kolloidal gelöst ist.

Aus der deutschen Offenlegungsschrift DE 195 02 541 ist ein elektrolumineszierendes System mit einer lichtemittierenden Substanz bekannt. Dabei ist vorgesehen, dass die lichtemittierende Substanz von anorganischen Partikeln mit Korngrößen im Nanobereich gebildet wird, die über organische Abstandshalter miteinander verbunden werden.

Die europäische Patentanmeldung EP 0 777 279 beschreibt eine Zwischenschicht in elektrolumineszierenden Anordnungen, die feinteilige anorganische Nanoteilchen enthalten.

Des weiteren sind aus der PCT-Anmeldung WO 00/20916 elektrische, chemische und mechanische Strukturen, die auf Nanoteilchen basieren, bekannt.

Aus Thin Solid Films, 349 (1999), Seiten 105-109 ist die Abscheidung und Charakterisierung von Composite-Schichten aus CdS und Polyaniline bekannt. In Applied Physics Letters, 74 (1999), Nr. 16, Seiten 2262-2264 wird die Synthese von amorphen GaN Nanopartikeln durch die *in situ* thermische Zersetzung von in einem Polymer eingeschlossenem Cyclotrigallazan sowie die Photolumineszenz der Nanopartikel beschrieben. In Applied Physics Letters, 70 (1997), 18, Seiten 2335-2337 wird die Photolumineszenz und Elektrolumineszenz von ZnS:Cu Nanokristallen in polymeren Netzwerken untersucht.

In [12] werden Halbleitervorrichtungen beschrieben, bei denen eine einzelne Schicht, die partikelförmiges halbleitendes Material und ein Matrixmaterial aufweist, zwischen einem metallischen Schichten angeordnet ist.

In [13] werden Substrate beschrieben, die lediglich eine Schicht aus CdSe und einem organischen Polymermaterial aufweisen.

In [14] werden CdSe/Polymer-Nanokomposite und deren optischen Eigenschaften beschrieben.

In [15] werden eine photovoltaische Vorrichtung und ein Herstellungsverfahren dazu beschrieben, wobei die Vorrichtung eine zwischen einer einkristallinen Halbleiterschicht und einer Elektrodenschicht angeordnete Schicht aus partikelförmigem halbleitendes Material, das mit der einkristallinen Halbleiterschicht und der Elektrodenschicht kontaktiert, und elektrisch isolierendem Matrixmaterial enthält.

In [16] wird eine Solarzelle beschrieben, bei der eine einzelne, in einer dielektrischen Matrix eingebettetes partikelförmiges Silizium aufweisende Schicht zwischen zwei leitenden Schichten angeordnet ist, wobei die Siliziumpartikel der einzelnen Schicht jeweils einen n-dotierten Bereich und einen p-dotierten Bereich aufweisen.

In [17] und [18] werden Ladungstrennungseffekte in Kompositen aus CdSe-Nanokristallen und jeweils einem konjugierten Polymer, insbesondere in einem Komposit mit dem halbleitenden Polymer MEH-PPV, mittels Messungen der Photoluminiszenz und der photoinduzierten Absorption bzw. der Photoleitfähigkeit untersucht.

In [19] werden Nanopartikel aus Galliumnitrid und deren Wechselwirkung mit organischen Molekülen untersucht.

In [20] wird ein organisches Feldeffektelement beschrieben, bei dem eine erste organische Schicht einen Kanal zwischen einer Source- und einer Drainelektrode bildet und eine zweite organische Schicht, die eine zur Ladungsträgerkonzentration der ersten Schicht unterschiedliche Ladungsträgerkonzentration hat, an die erste organische Schicht anschließend gebildet ist.

In [21] wird eine organische Solarzelle beschrieben, bei der zwischen einer ersten und einer zweiten halbleitenden Schicht Zwischenschichten angeordnet sind, welche die halbleitenden Materialien der ersten bzw. der zweiten Schicht und eine darin kolloidal gelöste Substanz enthalten.

Der Erfindung liegt daher das Problem zugrunde, ein elektronisches Halbleiterbauelement bereitzustellen, das sich auf einfache und kostengünstige Weise herstellen lässt und zugleich eine zufriedenstellende Qualität und Leistungsfähigkeit besitzt.

Das Problem wird durch ein elektronisches Bauelement mit den Merkmalen gemäß den unabhängigen Patentansprüchen gelöst. Ein solches elektronisches Bauelement weist ein Substratmaterial und auf das Substratmaterial aufgebrachte halbleitende Schichten auf, wobei das elektronische Bauelement mindestens einen Halbleiterübergang zwischen zwei halbleitenden Schichten aufweist, die jeweils ein inertes nichtleitendes Matrixmaterial aufweisen, in das ein anorganisches halbleitendes Material in Partikelform eingebettet ist. Dabei ist das Matrixmaterial ein organisches Polymer, ein anorganisches Keramikmaterial oder eine Mischung daraus ist.

Eine elektronische Schaltung ist ein mit mindestens einem solchen Bauelement aufgebauter Schaltkreis.

Der vorliegenden Erfindung liegt daher die Erkenntnis zugrunde, dass es für die Halbleiter-Funktionalität eines Bauelements wie ein Mikrochip nicht notwendig ist, die unterschiedlich (n- und p-) halbleitenden Schichten als intakte Festkörper (polykristallines Material, Einkristalle) eines anorganisches Halbleiters (d.h. als Bulkmaterial) auszubilden, sondern, dass der für die Erzielung der Halbleiter-Eigenschaften erforderliche Ladungstransport über die in der Matrix aneinandergrenzenden suspendierten Partikel erfolgen kann. Diese Halbleiter weisen dabei eine Qualität und Leistungsfähigkeit auf, die mit der von polykristallinen Silizium-Substraten vergleichbar ist.

Neben diesen elektronischen Bauelementen stellt die vorliegende Erfindung ferner ein Verfahren bereit, zur Herstellung einem elektronischen Bauelements mit einem Substratmaterial und mit auf dem Substratmaterial aufgebrachten halbleitenden Schichten gemäß dem den unabhängigen Patentansprüchen, das die Schritte aufweist:
(a) Vorlegen eines inerten Matrixmaterials, das ein organisches Polymer, ein anorganisches Keramikmaterial oder eine Mischung daraus ist, dann
(b) Mischen eines pulverförmigen, anorganischen halbleitenden Materials mit dem inerten Matrixmaterial, dann
(c) Aufbringen der das Matrixmaterial enthaltenden Mischung auf dem Substratmaterial, und dann
(d) Verfestigen des Matrixmaterials, wobei das halbleitende anorganische Material in das Matrixmaterial eingebettet wird.

In der vorliegenden Erfindung kann jedes bekannte anorganische halbleitende Material eingesetzt werden. Allerdings finden, unter anderem aus Kostengründen, vorzugsweise gängige Halbleitermaterialien wie Silizium, Siliziumcarbid, Germanium, Galliumarsenid, Galliumnitrid, Indiumphosphid, Cadmiumselenid oder Mischungen davon Anwendung in der vorliegenden Erfindung. Ein besonders bevorzugtes Material ist polykristallines Silizium, das unter anderem als Abfall in der Herstellung von Silizium-Einkristallen beim Zonenschmelzen anfällt und das für die Verwendung als anorganisches Halbleitermaterial hier lediglich zerkleinert werden muss. Das Halbleitermaterial kann dotiert oder undotiert sein. Dadurch eröffnet die vorliegende Erfindung einen eleganten Weg zur Wiederverwertung von Abfällen aus der traditionellen Halbleiterfertigung. Ein weiterer Vorteil der vorstehend aufgeführten Materialien ist ihre Sprödigkeit, die den für die Herstellung der elektronischen Bauelemente im allgemeinen notwendigen Zerkleinerungsprozess erleichtert.

Die Partikelgröße des hier verwendeten anorganischen halbleitenden Materials beträgt im allgemeinen zwischen 100 µm und 10 nm, vorzugsweise zwischen 50 µm und 0,1 µm oder 0,05 µm. Allerdings ist die Partikelgröße nicht auf diesen Bereich begrenzt. Vielmehr können in der vorliegenden Erfindung einerseits auch größere Partikel eingesetzt werden, solange sie noch einen für die Erzielung der gewünschten Halbleitereigenschaften ausreichenden Ladungstransport bewirken können. Andererseits ist es ebenfalls möglich, kleinere Partikel zu verwenden, solange sie nicht durch das Auftreten quantenmechanischer Effekte - wie beispielsweise bei den sogenannten Quantumdots der Fall - die Halbleitereigenschaften nachteilig beeinflussen.

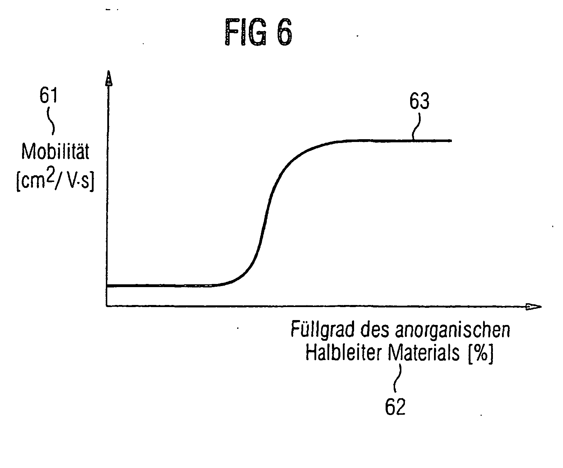

Der Gehalt (Füllgrad) des anorganischen halbleitenden Material in den halbleitenden Schichten des elektronischen Bauelements beträgt jeweils ca. 20 bis ca. 90 Vol.-%, vorzugsweise ungefähr 30 bis ungefähr 70 Vol.-%, bezogen auf das Gesamtvolumen der halbleitenden Schicht. Entsprechend ist das Matrixmaterial einschließlich der weiteren ggf. vorhandenen Bestandteile in der halbleitenden Schicht in einem Anteil von ca. 80 bis ca. 10 Vol.-%, vorzugsweise ungefähr 70 bis 30 Vol.-% vorhanden. Der jeweilige Füllgrad mit anorganischem halbleitenden Material hängt unter anderem von der gewünschten Mobilität der Ladungsträger ab. Zwischen dem Füllgrad 62 der halbleitenden Schicht und der Mobilität der Ladungsträger 61 (in cm²/V·s) besteht in der Regel eine sigmoidale oder ähnliche geartete Beziehung 63 (siehe Figur 6), so dass der gewünschte Füllgrad mit anorganischem Halbleitermaterial durch eine einfache Messreihe ermittelt werden kann. Die Mobilität der Ladungsträger ist überraschenderweise sehr hoch. So zeigen hier beschriebene Schichten in einer Feldeffekttransistoranordnung üblicherweise Mobilitäten im Bereich von 10⁻¹ bis 1·10⁷ cm²/V·s. Für die meisten der nachfolgend beschriebenen Anwendungen ist eine Mobilität von 1,5 cm²/V·s ausreichend.

Das hier offenbarte elektronische Bauelement zeichnet sich durch eine hohe chemische und physikalische Beständigkeit der halbleitenden Schicht gegenüber Umwelteinflüssen wie Temperatureinwirkung, UV-Einstrahlung, hohen Salzkonzentrationen und dgl. aus. So bleiben die elektrischen Eigenschaften der halbleitenden Schichten auch nach Temperatur - und/oder Salzsprühtests erhalten. Bei sogenannten Tape-Tests, in denen die Haftung auf dem Substrat überprüft wird, zeigen die Halbleiter-Schichten keine Delamination oder nur einen geringen Abtrag der Partikel. Darüber hinaus zeigen die halbleitenden Schichten eine hohe mechanische Abriebfestigkeit. Die Dicke der Schichten ist sehr variabel, im allgemeinen liegt sie im Bereich von 0,1 µm bis ca. 200 µm, vorzugsweise 1 µm bis 5 µm.

Ein inertes Matrixmaterial im Sinne der vorliegenden Erfindung ist prinzipiell jedes Material, das selbst nicht leitfähig ist, und das im festen Zustand die anorganischen Partikel einbettet, ohne den elektrischen Ladungstransport zu beeinträchtigen, der analog zur Situation in einem Festkörper-Halbleiter über die an den Korngrenzen der Partikel auftretenden Halbleitereffekte von statten geht. Als inerte Matrixmaterialien können hier organische Polymere (Polymermaterialien), anorganische Materialien sowie Mischungen davon verwendet werden.

Beispiele organischer Polymermaterialien sind gängige dielektrische synthetische Kunststoffe wie Epoxidharze, Polyalkylene wie Polyethylen- oder Polypropylenharze, Polystyrole, Polyurethane, Polyimide, Polybenzoxazole, Polyterephthalate, Polyethylennaphthalat, Polycarbonate aller Art und andere bekannte derartige Kunststoffe, wie sie beispielsweise auf den Seiten 8 bis 10, 110 bis 163 im Kunststoff-Kompendium, 2. Auflage 1988, Franck/Biederbick, Vogel-Buchverlag Würzburg, ISBN 3-8023-0135-8 beschrieben sind. Weiterhin können auch natürliche Polymermaterialien wie Natur- oder Kautschuklatex als organisches Polymermaterial verwendet werden. Die hier einsetzbaren Polymermaterialien können dabei Homopolymere, Copolymere sowie Mischungen aus Polymeren und Copolymeren, sogenannte Polymer-Blends, sein. Der hier verwendete Begriff Polymermaterialien schließt neben den polymeren Endprodukten auch deren entsprechenden Prepolymere ein.

Die hier verwendeten organischen Polymere sind vorzugsweise trockenbare und härtbare Materialien, vorzugsweise IR- und/oder UV-härtbare Polymere wie Polystyrole, Epoxidharze, Polyalkylene, Polyimide, Polybenzoxazole, Polyacrylate.

Anorganische Matrixmaterialien, die in der Erfindung verwendet werden Können, sind vorzugsweise anorganische Keramikmaterialien. Unter einem anorganischen Keramikmaterial, das hier als inertes Matrixmaterial eingesetzt werden kann, wird zum einem eines für die Herstellung von Tonwaren, keramischen Erzeugnisse, Steingut oder Porzellan verwendetes Rohmaterial verstanden. Beispiele solcher Materialien sind Silicate und Tonmineralien wie Kaolin oder Illit, weniger reine keramische Tone, die beispielsweise größere Mengen Quarz, Glimmer oder Sand enthalten. Im Sinne der vorliegenden Erfindungen sollen Fließ- oder Magerungsmittel wie Quarz oder Flußspat, die ebenfalls als Rohmaterialien, beispielsweise bei der Porzellanherstellung, verwendet werden, gleichfalls als Keramikmaterialien verstanden werden. Weitere Gruppen von hier verwendbaren Keramikmaterialien sind die sogenannten "Green Ceramics", die sich üblicherweise durch ihren niedrigen Schmelzpunkt von ca. 200°C bis 400°C oder knapp darüber auszeichnen, sowie die als Spin-on-Glass-Materialien bekannten Keramiken, wie z.B. Accuglass^{™} von der Firma AlliedSignal^{™}.

In einer weiteren Ausführungsform können die halbleitenden Schichten des hier beschriebenen elektronischen Bauelements ein unterstützendes halbleitendes organisches Material als Matrixmaterial enthalten. Dieses Material können organische halbleitende Polymere sein. Als Beispiele solcher Polymere seien hier Polythiophen, Polyanilin, Poly-p-phenylene, Poly-p-phenylvinylidene oder Polypyrol oder Phthalocyanine genannt. Gleichfalls können auch monomere bzw. niedermolekulare, unterstützende (halbleitende) organische Additive wie Pentazen oder Oligothiophene (beispielsweise mit 1 bis 10 Thiophen-Einheiten, vorzugsweise 6 Thiophen-Einheiten) als derartiges organisches Material enthalten sein. Der Anteil solcher unterstützenden Polymere und Additive in der halbleitenden Schicht beträgt in der Regel ungefähr 0,5 bis 25 Vol.-%, vorzugsweise maximal 10 Vol.-%.

In einer vorteilhaften Ausgestaltung der Erfindung emittiert das Matrixmaterial Licht.

Als Substratmaterial (Trägermaterial) zur Herstellung elektrischer Schaltungen und Bauteile kann in der vorliegenden Erfindung prinzipiell jedes Material eingesetzt werden, auf dem eine halbleitende Schicht dauerhaft aufgebracht werden kann. Beispiele geeigneter Substratmaterialien sind Isolatoren wie Papier, Kunststofffolien, Keramiken, Glas oder Kieselgelplatten, weiterhin Metall oder mit Kunststoff beschichtetes Metall. In einer vorteilhaften Ausgestaltung der Erfindung sind die leitenden Substrate transparent, beispielsweise beschichtet mit Indium-Zinnoxid (ITO). Es können auch (selbst elektrisch leitende und halbleitende) Substratmaterialien wie n-dotiertes oder p-dotiertes Silizium für die Herstellung von elektrischen Schaltungen eingesetzt werden.

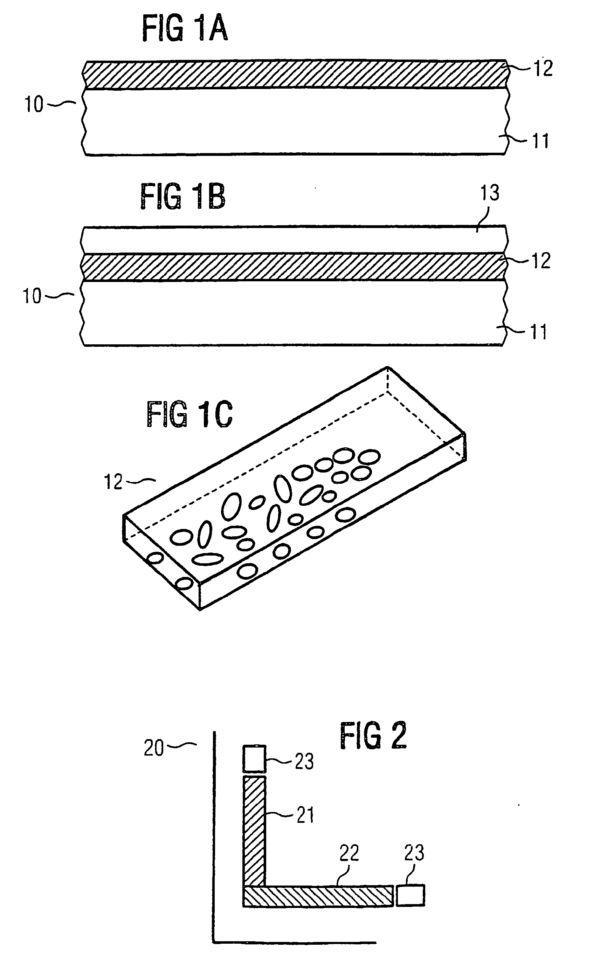

Unter Verwendung der hier beschriebenen halbleitenden Materialien und Substrate ist es möglich, jedes beliebige elektrische Bauelement bzw. jede beliebige Schaltung herzustellen. Beispiele von solchen Bauelemente sind Transistoren, Dioden, Leuchtdioden, die ihrerseits in Mikrochips, auf Leuchtdioden basierenden Displays, Solarzellen, passiven Bauelementen usw. Anwendung finden. Vorzugsweise sind in dem Bauelement der Erfindung alle Halbleiterübergänge mittels Kontaktierung der hier beschriebenen Schichten ausgebildet (vgl. z.B. Figuren 2 bis 4). Unter Halbleiterübergang werden hier sowohl Übergänge zwischen halbleitenden Bereichen mit Dotierungen unterschiedlichen Leitungstyps, z.B. zwischen n- und p-dotierten Bereichen, als auch Übergänge zwischen Bereichen mit unterschiedlichen Dotierstoffkonzentrationen des gleichen Leitungstyps, z.B. n- und n⁺-, verstanden. Diese Ausgestaltung der Halbleiterübergänge in dem hier offenbarten Bauelement hat den Vorteil, dass die Kontaktwiderstände niedrig sind und das Sperr-/Durchlassverhältnis ("on/off-ratio") gut ist.

Die Leistungsfähigkeit von Bauelementen, die unter Verwendung von halbleitenden Schichten hergestellt werden, steht aufgrund der oben beschriebenen erreichbaren Mobilitäten der Ladungsträger der von konventionellen Bauelementen in der Regel nichts nach. Falls gewünscht, lassen sich die elektrischen Eigenschaften der elektronischen Bauelemente und Halbleiter-Schaltungen durch einen zusätzlichen Temperschritt/Sinterschritt bei einer Temperatur vorzugsweise in einem Bereich zwischen 150°C und 700°C, vorzugsweise für Kunststoffmaterialien in einem Bereich zwischen 150°C und 400°C, verbessern.

Die wie hier erläutert hergestellten Bauelemente besitzen vielfältige Anwendungsgebiete. Aufgrund ihrer niedrigen Herstellungskosten werden sie vorzugsweise in der Kennzeichnungstechnologie eingesetzt, zum Beispiel bei der elektrischen Kennzeichnung von Waren für Logistik und Sicherheitszwecke, insbesondere für Produkte mit hohem Marktvolumen und/oder niedrigem Preis.

Beispielhafte Anwendungen sind hierbei der Barcodeersatz- oder -ergänzungen, elektronische Briefmarken, elektronische Preis- oder Haltbarkeitsschilder, fernabfragbare Sicherheitsmerkmale oder andere Anwendungen, die nach dem Transponderprinzip zum berührungslosen Informationsaustausch arbeiten. Eine weitere bevorzugte Hoch-Volumen-Anwendung der erfindungsgemäßen Bauelemente ist der Anteil von Smart-Cards, an den geringe Anforderungen gestellt werden. Dies sind beispielsweise Display-Treiber oder aktive Sicherheitsmerkmale.

Da eine druckbare Formulierung auf bekannten Tinten und Farben für die Tintenstrahltechnologie basieren kann, wird diese druckbare Formulierung im folgenden auch als Tinte bzw. Farbe bezeichnet.

Eine druckbare Zusammensetzung kann auf einer wässrigen Flüssigkeit, einer organischen Flüssigkeit, einem Gemisch aus zumindest zwei organischen Flüssigkeiten oder einen organischwässrigem Flüssigkeitsgemisch basieren. Diese Flüssigkeit kann als Lösungsmittel wirken, so dass in der Zusammensetzung das inerte Matrixmaterial entweder dispergiert oder auch gelöst sein kann. Anorganische Matrixmaterialien liegen vorzugsweise als Dispersion.in den Tinten vor, sie können aber auch in einer wässerigen oder organischen Lösung gelöst vorliegen. Ein Beispiel für ein gelöstes anorganisches Matrixmaterial stellt Natrium(ortho)silicat dar, das durch Zugabe von Säure verfestigt wird, und anschließend in einem Temperschritt unter Austritt von Wasser gesintert werden kann.

Organische Matrixmaterialien können in gelöster als auch in dispergierter Form vorliegen.

Bei Verwendung organischer Polymere als Matrixmaterial können diese Dispersionen sowohl Primärdispersionen sein, bei.denen die Polymerisation der entsprechenden Basis-Monomere direkt in der flüssigen Phase erfolgt (Emulsionspolymerisation, wie sie z.B. bei Acrylaten angewendet wird), als auch Sekundärdispersionen, in denen bereits vorgefertigte Polymere vorliegen. Solche Sekundärdispersionen werden zum Beispiel bei Polyurethanen oder-Polyvinylethern eingesetzt. Als Dispersionsmittel können dabei gleichermaßen druckbare wässrige und auch nicht-wässrige Dispersionsmittel dienen. Die Wahl des jeweiligen Dispersionsmittel hängt unter anderem von den ausgewählten Polymermaterialien und dem gewünschten Auftragungs-/Druckverfahren ab. Beispiele geeigneter Dispersionsmittel sind jede Art von Tensiden.

In einer bevorzugten Ausführungsform wird das als Matrixmaterial dienende organische Polymer in der Tinte gelöst. Als organisches Lösungsmittel können in der vorliegenden Erfindung prinzipiell alle für Polymere/Kunststoffe bekannte organischen Lösungsmittel und - mischungen verwendet werden, beispielsweise Tetrahydrofuran, Methylenchlorid, Chloroform, N-Methypyrrolidon, Xylole, γ-Butyrolacton, Methoxy-Propylacetat, Ethyllactat, Essigsäureethylester oder Cyclohexanon.

Das inerte Matrixmaterial und das anorganische halbleitende Material liegen in der druckbaren Zusammensetzung vorzugsweise in solchen Mengen vor, dass die unter Verwendung der druckbaren Zusammensetzung hergestellten halbleitende Schicht bzw. halbleitenden Schichten eines Substrats einen Gehalt an anorganischem halbleitenden Material von 20 bis 90 Vol.-%, bezogen auf das Gesamtvolumen der getrockneten Schicht nach Entfernung des Lösungsmittels, aufweist.

Die hier beschriebene Tinte/Farbe kann ferner Druck-Hilfsstoffe sowie die für die Polymerisation bzw. Aushärtung von polymeren Matrixmaterialien etwaig erforderlichen bekannten Katalysatoren und Hilfsmittel (Thixotropieeinsteller, Viskositätseinsteller, Korrosionsinhibitoren) enthalten.

Unter Druck-Hilfsstoffen werden hier sowohl Verbindungen verstanden, die das Aufbringen der Tinte auf das Substrat, d.h. den Druckvorgang als solchen verbessern helfen, als auch Stoffe, die die homogene Verteilung der Matrix auf dem Substrat begünstigen. Derartige Hilfsstoffe sind in der Tinte in der Regel in nur geringen Mengen, d.h. üblicherweise unter 3 Vol.-% enthalten.

Neben den vorstehend genannten Verbindungen kann eine druckbare Formulierung ferner noch in der Kunststofftechnik übliche Additive wie Stabilisatoren, Alterungsmittel und dgl. enthalten.

Die offenbarte Tinte wird vorzugsweise in Verbindung mit einem hier beanspruchten Verfahren zur Herstellung eines Substrats mit zumindest einem auf einem Substratmaterial aufgebrachten halbleitenden Material eingesetzt.

Bei einem ersten Verfahren umfasst die Ausbildung der halbleitenden Schichten jeweils die Schritte: (a) Vorlegen eines inerten Matrixmaterials, das ein organisches Polymer, ein anorganisches Material oder eine Mischung daraus ist, dann (b) Mischen eines pulverförmigen, anorganischen halbleitenden Materials mit dem inerten Matrixmaterial, vorzugsweise bis sich eine homogene Mischung gebildet hat, dann (c) Aufbringen der Mischung auf dem Substratmaterial, und dann (d) Verfestigen des Matrixmaterials, wobei das halbleitende anorganische Material in das Matrixmaterial eingebettet wird.

In einer bevorzugten Ausgestaltung dieses Verfahren ist die sich in Schritt (b) ergebende Mischung eine (homogene) Suspension. Bei dieser Ausgestaltung wird bei dem Verfahren somit in Schritt (b) das pulverförmige, anorganische halbleitende Material in dem inerten Matrixmaterial suspendiert, bis sich eine (homogene) Suspension gebildet hat, und in Schritt (c) wird die das Matrixmaterial enthaltende Suspension auf dem Substratmaterial aufgetragen.

Das Vorlegen und Mischen in den Schritten (a) bzw. (b) kann in der Weise durchgeführt werden, dass inertes Matrixmaterial in fester Form (beispielsweise in pulverförmiger oder granulierter Form) vorgelegt wird, danach pulverförmiges anorganisches Halbleiter-Material dazu gegeben wird und anschließend das Gemisch homogen vermahlen wird. Es entsteht somit dann eine feste, pulverförmige (Feststoff-) Mischung. Eine solche Vorgehensweise ist ebenfalls zum Beispiel bei Verwendung von Polystyrol als inertem Matrixmaterial möglich. Ein weiteres Beispiel ist ein Kunststoffmaterial wie ein Heißkleber-Granulat, das mit Partikeln aus anorganischem Halbleitermaterial gefüllt ist. Im allgemeinen sind derartige Heißkleber niedrigschmelzende thermoplastische Kunststoffe, d.h. Kunststoffe mit einem Schmelzpunkt von vorzugsweise ca. 150°C oder darunter.

Das Vorlegen des inerten Matrixmaterials in Schritt (a) kann zum Beispiel allerdings auch dadurch geschehen, dass ein inertes Matrixmaterial geschmolzen wird. Beispiele für geeignete schmelzbare Matrixmaterialien sind Kunststoffe wie Polystryrol oder anorganische Matrixmaterialien wie die oben genannten "Green Ceramics". Bei dieser Vorgehensweise ergibt sich dann in Schritt (b) eine Suspension, die dadurch hergestellt werden kann, dass das pulverförmige anorganische halbleitende Material (z.B. polykristallines Silizium) in die Schmelze eingemischt wird.

Das Aufbringen der Mischung bzw. Suspension aus inertem Matrixmaterial und halbleitendem anorganischen Halbleiter-Material in Schritt (c) kann bei den vorstehend beschrieben Vorgehensweisen durchgeführt werden, indem die Mischung oder Suspension erwärmt und somit fliess/druckfähig gemacht wird, falls sie nicht schon in fliessfähiger Form aus dem Schritt (b) hervorgeht.

In einer bevorzugten Ausführungsform des oben beschriebenen Herstellungsverfahrens wird in Verfahrensschritt (a) das inerte Matrixmaterial in einer Flüssigkeit (enthalten) vorgelegt. Folglich wird bei dieser Ausführungsform dann in Schritt (b) das pulverförmige, anorganische halbleitende Material in der Flüssigkeit suspendiert, bis sich eine homogene Suspension gebildet hat, die sowohl das Matrixmaterial als auch das halbleitende Material enthält.

Die Herstellung der Suspension aus anorganischem halbleitenden Material und der Flüssigkeit, die das inerte Matrixmaterial enthält, kann in der vorliegenden Erfindung auf jede beliebige, bekannte Weise (d.h. zum Beispiel Misch-/Rührtechnik) erfolgen, so lange eine ausreichende Homogenisierung (gemeinsames Vermahlen) erzielt wird.

Für das Auftragen auf das Substratmaterial wird die in Schritt (b) hergestellte Suspension vorzugsweise in eine geeignete Druck- oder Sprühvorrichtung überführt. Das Auftragen kann ebenfalls mit jedem bekannten und dazu geeigneten Verfahren erfolgen. So können für diesen Zweck beispielsweise Sprühverfahren für metallische Tinten auf wässriger und/oder organischer Lösungsmittel-Basis, die sonst zur Herstellung für Abschirmungen in der Gehäusetechnologie Anwendung finden, eingesetzt werden.

Vorzugsweise werden hier Druckverfahren wie Tampon- Sieb-, Schablonen- oder gängige Tintenstrahldruckverfahren verwendet, da insbesondere mit letztgenannten problemlos eine Auflösung von mindestens 1200 dpi (20 µm) erzielt werden kann, welche für die oben genannten Einsatzzwecke von erfindüngsgemäß aufgedruckten Schaltungen ausreicht.

Ein weiteres Druckverfahren, das ebenfalls in der vorliegenden Erfindung eingesetzt werden kann, ist der Offsetdruck. Der Offsetdruck erfordert zwei flüssige miteinander nur schwer mischbare Phasen (Emulsionen), wobei die erste flüssige Phase hier beispielsweise eine wässrige Phase sein kann und die zweite eine organische Phase, die das inerte Matrixmaterial sowie partikelförmiges anorganisches Halbleitermaterial enthält. Diese beiden Phasen werden beim Offsetdruck zunächst auf eine mit hydrophile und hydrophobe Bereiche strukturierte Druckplatte übertragen, wodurch sich die beiden Phasen (voneinander) trennen. Anschließend können die so erzeugten Strukturen gezielt auf ein hier eingesetztes Substratmaterial übertragen werden.

Liegen die hier beschriebenen druckbaren Zusammensetzungen als eine feste, pulverförmige Mischung vor, z.B. als eine Mischung aus pulverförmigen n- halbleitenden oder p-halbleitenden Silizium und einen granulierten/pulverförmigen Kunststoff, kann darüber hinaus Laserdruck zum Auftragen der Zusammensetzungen, d.h. als Druckverfahren, eingesetzt werden, da diese Zusammensetzungen einem konventionellen Toner für den Laserdruck entsprechen. Mit solchen Laserdruckverfahren können ebenfalls problemlos eine Auflösung vom mehr als 1200 dpi erzielt werden.

Das - wie vorstehend beschrieben - auf das Trägermaterial aufgebrachte Matrixmaterial wird in der Regel durch Entfernen der das Matrixmaterial enthaltenden Flüssigkeit verfestigt. Dabei wird die Flüssigkeit vorzugsweise durch Trocknen entfernt. Das Trocknen wird vorzugsweise durch Bestrahlung mit Infrarotlicht (IR) durchgeführt, da diese Bestrahlung zum einen in der Serienproduktion der Substrate einfach durchführbar ist, und zum anderen bei Verwendung von wärmehärtbaren organischen Polymermaterialien (Kunststoffen) wie Epoxidharze zugleich die Aushärtung des Matrixmaterials fördert bzw. bewirkt. Es können jedoch, abhängig von der Art des eingesetzten Matrixmaterials, auch andere bekannte Trocknungs- bzw. Verfestigungsverfahren (Härtungsverfahren) eingesetzt werden. Beispielsweise kann die Trocknung auch im Vakuum, d.h. durch Vakuumtechniken, geschehen. Bei Verwendung von UV-härtbaren Kunststoffen erfolgt das Aushärten vorzugsweise durch UV-Bestrahlung.

Als Alternative zu dem vorstehend beschriebenen Verfahren kann ein elektronisches Bauelement mit einem Substratmaterial und mit auf dem Substratmaterial aufgebrachten halbleitenden Schichten gemäß den unabhängigen Patentansprüchen durch ein Verfahren erhalten werden, bei dem die Ausbildung der halbleitenden Schichten jeweils die Schritte aufweist:
(a) Vorlegen eines inerten Matrixmaterials, das ein organisches Polymer, ein anorganisches Keramikmaterial oder eine Mischung daraus ist, dann
(b) Aufbringen des Matrixmaterials auf dem Substratmaterial, und dann
(c) Suspendieren eines pulverförmigen, anorganischen halbleitenden Materials in dem inerten Matrixmaterial, bis sich eine homogene Suspension gebildet hat, bei der halbleitende anorganische Material in das Matrixmaterial eingebettet ist.

Ein solches Verfahren ist zum Beispiel so ausgestaltet, dass als inertes Matrixmaterial ein thermoplastischer Kunststoff wie Polystyrol, Polyethylen oder Polypropylen verwendet wird, der auf ein Substratmaterial zum Beispiel als Schmelze aufgetragen wird, und danach die Suspension in Schritt (c) dadurch gebildet wird, dass Partikel eines anorganischen Halbleiters in die Schicht des Matrixmaterials eingewalzt werden. Dieses Verfahren ist insbesondere im Hinblick auf die Bildung der Grenzschicht zwischen dem Substrat und der halbleitenden Schicht besonders vorteilhaft, da es ermöglicht, dass die halbleitenden Partikel nur in den oberen Bereich der halbleitenden Schicht eingebettet werden und somit der unmittelbar an das Substratmaterial angrenzende Bereich nichtleitend bliebt.

Dieses Verfahren kann weiterhin als Schritt (d) das Verfestigen des Matrixmaterials auf dem Substratmaterial aufweisen.

Mit Hilfe des hier beschriebenen Verfahren kann ein halbleitendes Substrat beliebig strukturiert werden, indem halbleitenden Schichten in beliebiger (geometrischer) Anordnung auf dem gewünschten Substratmaterial aufgebracht werden. So sind Substrate mit mehreren übereinanderliegenden halbleitenden Schichten, d.h. mehrschichtige Substrate, oder gitter/raster-förmig angeordneten Schichten problemlos zu realisieren. Das "Drucklayout" zur Strukturierung kann bei dem vorstehend beschriebenen Verfahren leicht geändert werden.

Ausführungsbeispiele der vorliegenden Erfindung sind in den folgenden Figuren und Beispielen weiter veranschaulicht.

Es zeigen
Figuren 1A und 1B eine Schnittansicht eines Substrats, bei dem auf das Trägermaterial eine bzw. zwei halbleitende Schichten aufgebracht sind;
Figur 1C eine schematische Darstellung einer hier beschriebenen halbleitenden Schicht;
Figur 2 eine gemäß einem Herstellungsbeispiel 1 der Erfindung hergestellte Diode gemäß einem Ausführungsbeispiel 1 der Erfindung;
Figuren 3A bis 3C einen MOS (Metal-Oxid-Semiconductor)-Feldeffekttransistor (MOSFET) gemäß einem anderen Ausführungsbeispiel 2 der Erfindung;
Figur 4 einen Bipolartransistor gemäß noch einem anderen Ausführungsbeispiel 3 der Erfindung;
Figur 5A eine Leuchtdiode;
Figur 5B eine Leuchtdiode gemäß noch einem anderen Ausführungsbeispiel 4 der Erfindung;
Figur 6 eine beispielhafte und schematische Darstellung einer Auftragung der Mobilität der Ladungsträger in einer halbleitenden Schicht eines Substrats als Funktion des Füllgrads des anorganischen halbleitenden Materials in der Schicht;
Figuren 7A bis 7C gemäß einem weiteren Herstellungsbeispiel 2 hergestellte Dioden (Fig. 7A), die Partikelgrößenverteilung der Siliziumpartikel, die in einer halbleitenden Schicht der Dioden eingebettet sind (Fig. 7C), sowie die Strom-Spannungskennlinie der Dioden (Fig 7C).

Die Figuren 1A und 1B zeigen eine Schnittansicht eines Substrats 10, bei dem auf dem Trägermaterial 11 eine bzw. zwei halbleitende Schichten 12, 13 aufgebracht sind. In Figur 1C ist die halbleitende Schicht 12 aus inertem Matrixmaterial und darin dispergiertem anorganischen Halbleiter-Material schematisch dargestellt.

### Ausführungsbeispiel 1

Dieses Beispiel zeigt eine gemäß Herstellungsbeispiel 1 hergestellte und in Figur 2 wiedergegebene Diode 20. Diese weist eine erste halbleitende Schicht 21 auf, bei der p-leitendes partikelförmiges Silizium in eine Polystyrolmatrix eingebettet ist, und eine zweite halbleitende Schicht 22, bei der n-leitendes partikelförmiges Silizium in eine Polyacrylsäurematrix eingebettet ist, wobei, die Schicht 22 zum einen senkrecht zur ersten Schicht 21 und zum anderen (zur Vergrößerung der Kontaktfläche) auf der ersten Schicht 21 angeordnet ist. Ferner sind bei der Diode 20 die Schichten 21 und 22 mit einer kommerziell erhältlichen Cu/Ag-Tinte 23 kontaktiert.

### Ausführungsbeispiel 2

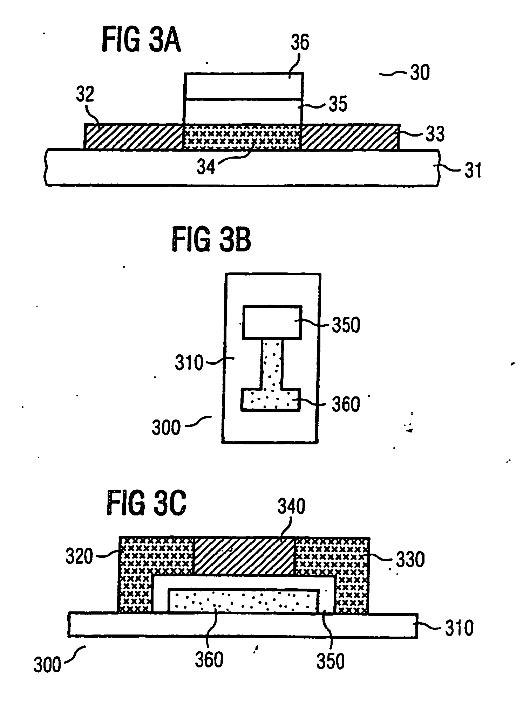

Dieses Beispiel zeigt einen Metall-Oxid-Halbleiter-Feldelektronentransistor (MOSFET) gemäß Figur 3.

Bei dem MOSFET 30 gemäß Figur 3A sind auf einem Substratmaterial 31 zwei Schichten 32 und 33 aus einem n-leitenden pulverförmigen Halbleitermaterial, das in einem inertem Matrixmaterial dispergiert ist, sowie eine Schicht 34 aus in einem inerten Matrixmaterial eingebetteten p-leitendem Halbleitermaterial aufgetragen. Die Schicht 34 ist zwischen den beiden Schichten 32 und 33 angeordnet und steht mit den beiden Schichten in Kontakt. Die Schicht 34 dient als Kanalbereich des MOSFETs. Auf der Schicht 34 ist eine Oxidschicht 35 aufgebracht, auf der sich ein metallisches Gate 36 befindet. Die Oxidschicht 35 kann eine solche Oxidschicht sein, wie sie in konventionellen MOSFETs vorkommt. Allerdings ist die Schicht 35 vorzugsweise eine Schicht aus einem druckbaren Material wie einem dielektrischen Kunststoff oder einem Spin-on-Glass-Material, so dass ein zu einem klassischem MOS-FET analoges Bauteil 30 ausgebildet wird. Das metallische Gate ist zum Beispiel eine druckbare Cu/Ag-Tinte.

Bei dem einem MOSFET entsprechenden Bauelement 300 gemäß Figuren 3B und 3C, von denen Figur 3B eine Draufsicht und Figur 3C ein Schnittansicht zeigt, ist das Substratmaterial 310 eine mit Kupfer strukturierte Leiterplatte (Basismaterial FR4), auf der sich eine Kupfer-Tinte als metallisches Gate 360 befindet, ein aufgedrucktes Kunststoff-Dielelektrikum 350, die einer Oxidschicht eines MOSFETs entspricht, sowie zwei Schichten 320 und 330 aus einem p-leitenden pulverförmigen Halbleitermaterial, das in einem inerten Matrixmaterial dispergiert ist, sowie eine Schicht 340 aus in einem inerten Matrixmaterial eingebetteten n-leitendem Halbleitermaterial aufgetragen.

### Ausführungsbeispiel 3

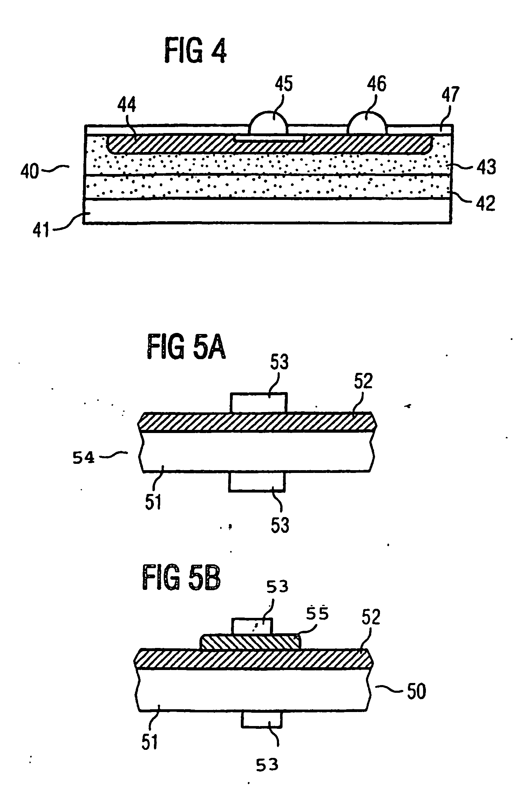

Dieses Beispiel zeigt einen planaren Bipolartransistor 40 gemäß Figur 4. Dieser Bipolartransistor 40 weist auf einem Trägermaterial 41 zunächst eine erste n-halbleitende Schicht 42 aus inertem Matrixmaterial und n-halbleitenden anorganischen Partikeln auf sowie eine zweite ebenfalls n-halbleitende Schicht 43 aus in ein inertes Matrixmaterial eingebetteten n-halbleitenden anorganischen Partikeln. Die Schicht 42 stellt den Kollektor des Transistors dar. Auf der zweiten Schicht 42 bzw. in dieser Schicht ist eine Schicht 44 angeordnet, bei ein anorganischer p-Halbleiter in eine inertes Matrixmaterial eingebettet ist. Die Schicht 44 bildet die Basis des Transistors. Der Bipolartransistor 40 weist ferner die erforderliche Emitterelektrode 45 und Basiselektrode 46 mit den dazugehörigen Emitter- und Basisansschlüssen sowie eine Schutzschicht 47 auf.

### Ausführungsbeispiel 4

Dieses Beispiel zeigt eine Leuchtdiode 50 gemäß Figur 5. Dabei zeigt zunächst Figur 5A eine Schnittansicht einer Leuchtdiode 54, bei der als Substratmaterial ein n-dotierter Galliumarsenid-Einkristall 51 verwendet wird und auf die eine halbleitende Schicht 52 aufgebracht ist. Das anorganische halbleitende Material, das in die halbleitende Schicht 52 in dispergierter Form eingebettet ist, ist Galliumarsenid, das mit Zink (Zn) dotiert ist. Durch die Dotierung mit Zink ist die Schicht 52 zum einen p-leitend, zum anderen bewirkt die Zn-Dotierung die Ausbildung einer Diode, die bei einer Wellenlänge von 900 nm emittiert, nachdem der Einkristall 51 sowie die Schicht 52 zum Beispiel mit einer Cu/Ag-Tinte 53 kontaktiert sind. Die Diode 50 gemäß Figur 5A ist somit ein Beispiel für ein Substrat, bei dem das Substratmaterial selbst ein halbleitendes Material ist.

Figur 5B zeigt eine Schnittansicht einer Diode 50, bei der auf einem Trägermaterial 51 zunächst ein erste halbleitende Schicht 52 aufgetragen ist, bei der Galliumarsenid-Partikel in ein inertes Matrixmaterial eingebettet sind, und dann eine zweite halbleitende Schicht 55 aufgetragen ist, bei der mit Zink dotierte Partikel aus Galliumarsenid eingebettet sind. Nach Kontaktierung mit einer Cu/Ag-Tinte 53 emittiert diese Diode 50 ebenfalls Infrarotstrahlung mit 900 nm Wellenlänge.

### Herstellungsbeispiel 1

### Dieses Beispiel soll das hier beanspruchte Herstellungsverfahren erläutern.

In eine wässrige Polyacrylsäurelösung (35 Gew.-%) wird n-leitendes Silizium (durchschnittlicher Korndurchmesser 5 µm) eingerührt und aus der homogenen Suspension (n-Tinte) wird eine 200 µm breite und 1 mm lange Bahn 21 durch eine Stencil-Maske auf eine Polyethylennaphthalatfolie als Substratmaterial aufgedruckt und anschließend für 30 Minuten im Vakuum bei 60°C getrocknet. Danach wird in eine Polystyrol-Lösung (Lösungsmittel Xylol) p-leitendes Silizium (durchschnittlicher Korndurchmesser 5 µm) eingerührt und die daraus erhaltene p-Tinte wird in senkrechter Anordnung zu der n-leitenden Bahn aufgedruckt und 30 Sekunden unter einem IR-Strahler (Leistung: 1000 W) getrocknet. Je ein Ende der n-leitenden und p-leitenden Bahn wird mit einer kommerziellen Cu/Ag-Tinte 23 kontaktiert. Die so hergestellte Diode kann mit 100 mA belastet werden. Die Sperrspannung beträgt 100 V.

### Herstellungsbeispiel 2

Diese Beispiel erläutert ein weiteres Herstellungsverfahren von Dioden als Beispiele für Bauteile, die eine der hier beschriebenen, inertes Matrixmaterial und anorganisches halbleitendes Material in Partikelform enthaltenden Schichten aufweist und veranschaulicht die Eigenschaften dieser Dioden.

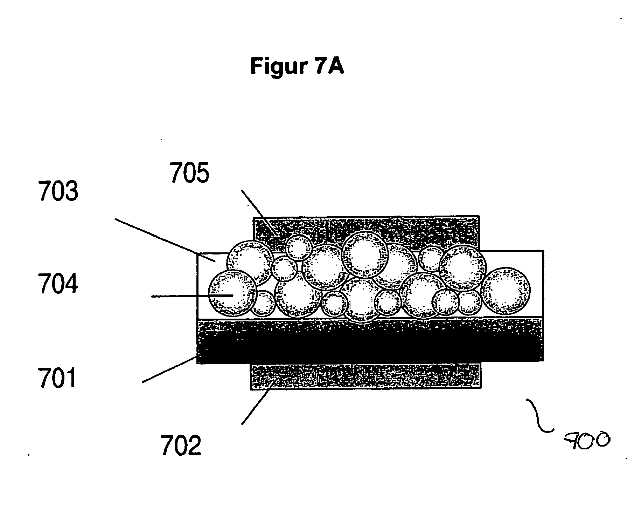

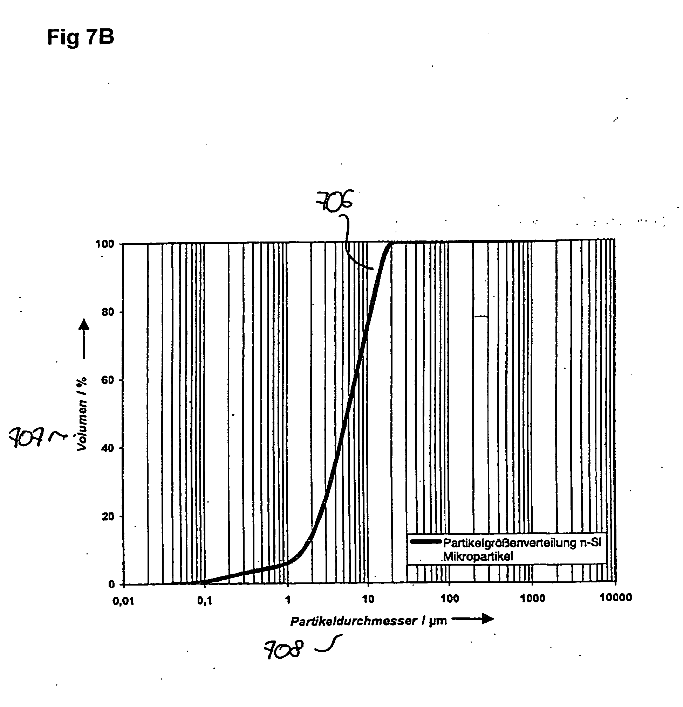

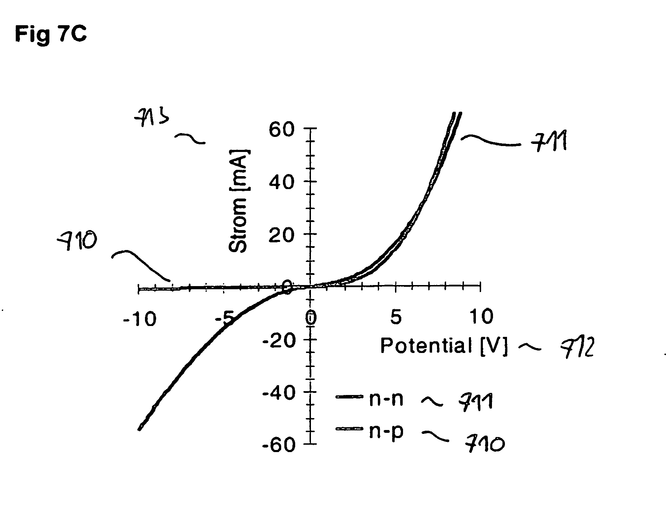

Zunächst wird eine Lösung hergestellt, die ein organisches Polymer als Matrixmaterial sowie halbleitende anorganische Partikel enthält. Dazu werden 6 g Polystyrol und 24 g n-dotiertes Silizium in 70 ml Xylol gelöst bzw. suspendiert, indem die Suspension zuerst 10 Stunden intensiv geschüttelt und anschließend 20 min in einem Ultraschallbad homogenisiert wird. Das eingesetzte n-dotierte Silizium weist einen durchschnittlichen spezifischen elektrischen Widerstand von r = 4 Ωcm auf, 99 % der Partikel haben eine Partikelgröße von < 15 µm (siehe Fig. 7B, in der die Partikelgrößenverteilung 706 in Form des Partikeldurchmesser 708 in µm gegen den aufsummierten prozentualen Volumenanteil 707 der Partikel mit dem jeweiligen Partikeldurchmesser aufgetragen ist).

Für die Herstellung der Diodenstruktur 700 werden zunächst auf die Rückseite eines Siliziumwafers 701 100 nm Palladium vollflächig gesputtert, um mit Hilfe der so entstandenen Palladiumschicht 702 einen eindeutig ohmschen Kontakt zu erzeugen. Anschließend wird auf die Vorderseite die das n-dotierte Silizium enthaltende Suspension bei 1000 Umdrehungen/min aufgeschleudert und bei 100°C und 120°C je 5 min auf einer Hotplate getrocknet. Dabei wird eine 68µm dicke Schicht 703 aus elektrisch inertem Matrixmaterial mit darin eingebetteten Halbleiterpartikeln 704 erhalten. Auf diese Schicht 703 wird durch eine Schattenmaske wiederum eine Schicht 705 aus 100 nm Palladium aufgesputtert. Die Schattenmaske definiert runde Bereich mit einem Durchmesser von 2 mm.

Auf diese Weise wurden unter Verwendung eines n-dotierten Siliziumwafers 701 und eines p-dotierten Silizium-Wafers 701 zwei Diodenstrukturen 700 erhalten. Von beiden Dioden wurde eine Strom/Spannungskennlinie (I/U Kennlinie) aufgezeichnet. Die I/U Kennlinie 710 der Diodenstruktur, die mit dem p-leitenden Silizium-Wafers hergestellt wurde, zeigt dabei eindeutig einen p-n Übergang. Die I/U Kennlinie 711 der mit dem Wafer aus n-Silizium ausgebildeten Diodenstruktur ist symmetrisch. Die Abweichung vom ohmschen Verhalten wird durch die Energiebarriere des Ladungsübergangs zwischen den Partikeln bestimmt.

In diesem Dokument sind folgende Veröffentlichungen zitiert:
[1] WO 99/39373
[2] WO 99/19900
[3] DE 198 54 938
[4] DE 199 05 694
[5] DE 195 02 541
[6] EP 0 777 279
[7] WO 00/20916
[8] Pethkar et al., Thin Solid Films, 349 (1999), Seiten 105-109
[9] Yang et al., Applied Physics Letters, 74 (1999), 16, Seiten 2262-2264
[10] Huang et al., Applied Physics Letters, 70 (1997), 18, Seiten 2335-2337
[11] Kunststoff-Kompendium, 2. Auflage 1988, Franck/Biederbick, Vogel-Buchverlag Würzburg, ISBN 3-8023-0135-8 Seiten 8-10, 110-163
[12] US-A-4 947 219
[13] Kuczkowski A, "The prospects for polyester polymer-CdS powder composites in photoelectronic device applications", Journal of Physics D. Applied Physics, IOP Publishing Bristol, Bd. 22, Nr. 11, 14. November 1989, Seiten 1731-1735
[14] Tridade T et. al., "Preparation and optical properties of CdSe/polymer nanocomposites" Scripta Materialia, Elsevier, New York, Bd. 43, Nr. 6, 28. August 2000, Seiten 567-571
[15] US-A-5 868 869
[16] US-A-5 672 214
[17] Ginger D. et_ al., "Charge Separation in conjugatedpolymer/nanocrystal blends", Synthetic Metals, Elsevier Sequoia, Lausanne, Bd. 101, Nr. 1/3, 1999, Seiten 425-428
[18] Greenham N. et. al., "Charge separation and transport in conjugated polymer/cadmium selenide nanocrystal composites studied by photoluminiscence quenching and photoconductivity", Synthetic Metals, Elsevier Sequoia, Lausanne, Bd. 84, Nr. 1/3, 1997, Seiten 545-546
[19] Baraton M.-I. et. al., "DRIFTS characterization of a nanostructured gallium nitride powder and its interactions with organic molecules", Materials Science and Engineering B, Esevier Sequoia, Lausanne, Bd. 50, Nr. 1-3, 18. Dezember 1997, Seiten 42-45
[20] EP-A-0 528 662
[21] WO 00/33396 A

### Bezugszeichenliste

- 10: Substrat
- 11: Trägermaterial
- 12: halbleitende Schicht
- 13: halbleitende Schicht

- 20: Diode
- 21: halbleitende Schicht
- 22: halbleitende Schicht
- 23: Cu/Ag-Tinte

- 30: MOSFET
- 31: Substratmaterial
- 32: n-halbleitende Schicht
- 33: n-halbleitende Schicht
- 34: p-halbleitende Schicht
- 35: Oxidschicht
- 36: metallisches Gate

- 300: einem MOSFET entsprechendes Bauelement
- 301: Bauelement
- 310: Substratmaterial
- 320: p-halbleitende Schicht
- 330: p-halbleitende Schicht
- 340: n-halbleitende Schicht
- 350: Kunststoff-Dielelektrikum
- 360: metallisches Gate

- 40: planarer Bipolartransistor
- 41: Trägermaterial
- 42: n-halbleitende Schicht (Kollektor)
- 43: n-halbleitende Schicht
- 44: p-halbleitende Schicht (Basis)
- 45: Emitterelektrode
- 46: Basiselektrode
- 47: Schutschicht

- 50: Leuchtdiode
- 51: n-dotierter Galliumarsenid-Einkristall
- 52: halbleitende Schicht
- 53: Cu/Ag-Tinte
- 54: Leuchtdiode
- 55: Cu/Ag-Tinte

- 61: Mobilität der Ladungsträger
- 62: Füllgrad
- 63: Beziehung zwischen Füllgrad und Mobilität der Ladungsträger

- 700: Diode
- 701: Siliziumwafer
- 702: Palladiumschicht
- 703: Schicht aus inertem Matrixmaterial
- 704: Halbleiterpartikel
- 705: Palladiumschicht
- 706: Partikelgrößenverteilung
- 707: Volumenanteil
- 708: Partikeldurchmesser
- 710: Strom/Spannungskennlinie von n-n-Diode
- 711: Strom/Spannungskennlinie von p-n-Diode
- 713: Potential
- 714: Strom

## Patentansprüche

1. Elektronisches Bauelement (20, 30, 300, 40, 50) mit einem Substratmaterial (31, 310, 41, 51) und mit auf dem Substratmaterial aufgebrachten halbleitenden Schichten (21, 22, 32, 33, 34, 320, 330, 340, 42, 43, 44, 52, 53), wobei
das elektronische Bauelement mindestens einen Halbleiterübergang zwischen zwei halbleitenden Schichten (21, 22, 32, 33, 34, 320, 330, 340, 42, 43, 44, 52, 53) aufweist, die jeweils ein inertes nichtleitendes Matrixmaterial aufweisen, in das ein anorganisches halbleitendes Material in Partikelform eingebettet ist, **dadurch gekennzeichnet, dass** das Matrixmaterial ein organisches Polymer, ein anorganisches Keramikmaterial oder eine Mischung daraus ist.

2. Elektronisches Bauelement (20, 30, 300, 40, 50) nach Anspruch 1, bei dem das anorganische halbleitende Material aus der Gruppe ausgewählt wird, die aus Silizium, Siliziumcarbid, Germanium, Galliumarsenid, Galliumnitrid, Indiumphosphid, Cadmiumselenid oder Mischungen davon besteht.

3. Elektronisches Bauelement (20, 30, 300, 40, 50) nach Anspruch 1 oder 2, bei dem das anorganische halbleitende Material eine Partikelgröße zwischen 100 µm und 10 nm aufweist.

4. Elektronisches Bauelement (20, 30, 300, 40, 50) nach einem der Ansprüche 1 bis 3, bei dem die halbleitenden Schichten (21, 22, 32, 33, 34, 320, 330, 340, 42, 43, 44, 52, 53) einen Gehalt an anorganischem halbleitenden Material von 20 bis 90 Vol.-%, bezogen auf ihr Gesamtvolumen, aufweisen.

5. Elektronisches Bauelement (20, 30, 300, 40, 50) nach einem der Ansprüche 1 bis 4, bei dem das organische Polymer aus der Gruppe ausgewählt wird, die aus Epoxidharzen, Acrylaten, Polyimiden, Polybenzoxazolen, Polystyrol und Polyalkylenen besteht.

6. Elektronisches Bauelement (20, 30, 300, 40, 50) nach einem der vorhergehenden Ansprüche, bei dem das Matrixmaterial, ferner ein halbleitendes organisches Material enthält.

7. Elektronisches Bauelement (20, 30, 300, 40, 50) nach einem der vorhergehenden Anspruch, bei dem das Substratmaterial (31, 310, 41, 51) aus der Gruppe ausgewählt wird, die aus Papier, Kunststofffolien, Keramiken, Glas, Kieselgelplatten, weiterhin Metall, mit Kunststoff beschichtetes Metall, Indium-Zinnoxid, elektrisch leitenden oder elektrisch halbleitenden Substratmaterialien, besteht.

8. Elektronisches Bauelement (20, 30, 300, 40, 50) nach einem der Ansprüche 1 bis 7, bei dem das Bauelement eine Diode (20, 50) oder ein Transistor (30, 300, 40) ist.

9. Elektronisches Bauelement (20, 30, 300, 40, 50) nach Anspruch 8, das ein Transistor (30, 300, 40) ist, bei dem der Source-Bereich und der Drain-Bereich aus n-leitendem pulverförmigen Halbleitermaterial in einem inerten Matrixmaterial aufgebaut sind und der Kanalbereich (34) des Transistors ein inertes nichtleitendes Matrixmaterial mit eingebettetem p-leitenden Halbleitermaterial aufweist.

10. Elektronische Schaltung mit mindestens einem elektronischen Bauelement (20, 30, 300, 40, 50) nach einem der Ansprüche 8 oder 9.

11. Verfahren, zur Herstellung eines elektronischen Bauelements (20, 30, 300, 40, 50) gemäß Anspruch 1, wobei bei dem Verfahren die Ausbildung der halbleitenden Schichten jeweils die Schritte aufweist:
(a) Vorlegen eines inerten nichtleitenden Matrixmaterials, das ein organisches Polymer, ein anorganisches Keramikmaterial oder eine Mischung daraus ist, dann
(b) Mischen eines pulverförmigen, anorganischen halbleitenden Materials mit dem inerten nichtleitenden Matrixmaterial, dann
(c) Aufbringen der das Matrixmaterial enthaltenden Mischung auf dem Substratmaterial (31, 310, 41, 51), und dann
(d) Verfestigen des Matrixmaterials, wobei das halbleitende anorganische Material in das Matrixmaterial eingebettet wird.

12. Verfahren nach Anspruch 11,
bei dem in Schritt (b) das pulverförmige, anorganische halbleitende Material in dem inerten nichtleitenden Matrixmaterial suspendiert wird, bis sich eine homogene Suspension gebildet hat, und
bei dem in Schritt (c) die das Matrixmaterial enthaltende Suspension auf dem Substratmaterial (31, 310, 41, 51) aufgetragen wird.

13. Verfahren nach Anspruch 12, bei dem in Schritt (a) das inerte nichtleitende Matrixmaterial in einer Flüssigkeit vorgelegt wird, und
bei dem in Schritt (b) das pulverförmige, anorganische halbleitende Material in der Flüssigkeit suspendiert wird.

14. Verfahren nach Anspruch 13, bei dem in Schritt (a) das inerte nichtleitende Matrixmaterial in der Flüssigkeit gelöst wird.

15. Verfahren nach Anspruch 13, bei dem in Schritt (a) das inerte nichtleitende Matrixmaterial in der Flüssigkeit suspendiert wird.

16. Verfahren nach einem der Anspruche 14 bis 15, bei dem die Flüssigkeit eine wässrige Flüssigkeit, eine organische Flüssigkeit, ein Gemisch aus zumindest zwei organischen Flüssigkeiten oder ein Gemisch aus wässriger und organischer Flüssigkeit ist.

17. Verfahren nach einem der Ansprüche 13 bis 16, bei dem die in Schritt (b) hergestellte Mischung oder Suspension in eine geeignete Druck- oder Sprühvorrichtung überführt wird.

18. Verfahren nach einem der Ansprüche 13 bis 16, bei dem in Schritt (d) die das Matrixmaterial enthaltende Flüssigkeit entfernt wird.

19. Verfahren nach Anspruch 18, bei dem die Flüssigkeit mittels IR-Bestrahlung und/oder Trocknen im Vakuum entfernt wird.

20. Verfahren nach Anspruch 19, bei dem das inerte nichtleitende Matrixmaterial ein organisches Polymer ist und sich durch Aushärten verfestigt.

21. Verfahren nach einem der Ansprüche 11 bis 20, bei dem das anorganische halbleitende Material eine Partikelgröße zwischen 100 µm und 10 nm aufweist.

22. Verfahren nach einem der Ansprüche 11 bis 20, bei dem das Substratmaterial (31, 310, 41, 51) aus der Gruppe ausgewählt wird, die aus Papier, Kunststofffolien, Keramiken, Glas, Kieselgelplatten, weiterhin Metall, mit Kunststoff beschichtetem Metall, Indium-Zinnoxid, elektrisch leitenden oder elektrisch halbleitenden Substratmaterialien besteht.

23. Verfahren nach einem der Ansprüche 11 bis 21, bei dem die Mischung oder Suspension auf dem Substrat durch ein Druckverfahren aufgebracht wird.

24. Verfahren nach Anspruch 23, bei dem als Druckverfahren Tampon- Sieb-, Schablonen-, Tintenstrahl-, Offset- und Laserdruck eingesetzt wird.

25. Verfahren, zur Herstellung eines elektronischen Bauelements gemäß Anspruch 1, wobei bei dem Verfahren die Ausbildung der halbleitenden Schichten jeweils die Schritte aufweist:
(a) Vorlegen eines inerten nichtleitenden Matrixmaterials, das ein organisches Polymer, ein anorganisches Keramikmaterial oder eine Mischung daraus ist, dann
(b) Aufbringen des Matrixmaterials auf dem Substratmaterial (31, 310, 41, 51), und dann
(c) suspendieren eines pulverförmigen, anorganischen halbleitenden Materials in dem inerten nichtleitenden Matrixmaterial, bis sich eine homogene Suspension gebildet hat, bei der das halbleitende anorganische Material in das Matrixmaterial eingebettet ist.

## Claims

1. An electronic component (20, 30, 300, 40, 50) having a substrate material (31, 310, 41, 51) and semiconducting layers (21, 22, 32, 33, 34, 320, 330, 340, 42, 43, 44, 52, 53) applied to the substrate material, wherein the electronic component includes at least one semiconductor junction between two semiconducting layers (21, 22, 32, 33, 34, 320, 330, 340, 42, 43, 44, 52, 53) which in each case include an inert nonconducting matrix material in which an inorganic semiconducting material is embedded in particle form, **characterized in that** the matrix material is an organic polymer, an inorganic ceramic material or a mixture thereof.

2. The electronic component (20, 30, 300, 40, 50) as claimed in claim 1, in which the inorganic semiconducting material is selected from the group consisting of silicon, silicon carbide, germanium, gallium arsenide, gallium nitride, indium phosphide, cadmium selenide or mixtures thereof.

3. The electronic component (20, 30, 300, 40, 50) as claimed in claim 1 or 2, in which the inorganic semiconducting material has a particle size of between 100 µm and 10 nm.

4. The electronic component (20, 30, 300, 40, 50) as claimed in one of claims 1 to 3, in which the semiconducting layers (21, 22, 32, 33, 34, 320, 330, 340, 42, 43, 44, 52, 53) have an inorganic semiconducting material content of from 20 to 90% by volume, based on their total volume.

5. The electronic component (20, 30, 300, 40, 50) as claimed in one of claims 1 to 4, in which the organic polymer is selected from the group consisting of epoxy resins, acrylates, polyimides, polybenzoxazoles, polystyrene and polyalkylenes.

6. The electronic component (20, 30, 300, 40, 50) as claimed in one of the preceding claims, in which the matrix material also includes a semiconducting organic material.

7. The electronic component (20, 30, 300, 40, 50) as claimed in one of the preceding claims, in which the substrate material (31, 310, 41, 51) is selected from the group consisting of paper, plastic films, ceramics, glass, silica gel plates, also metal, plastic-coated metal, indium tin oxide, electrically conducting or electrically semiconducting substrate materials.

8. The electronic component (20, 30, 300, 40, 50) as claimed in one of claims 1 to 7, in which the component is a diode (20, 50) or a transistor (30, 300, 40).

9. The electronic component (20, 30, 300, 40, 50) as claimed in claim 8, which is a transistor (30, 300, 40) in which the source region and the drain region are made up of n-conducting pulverulent semiconducting material in an inert matrix material and the channel region (34) of the transistor includes an inert nonconducting matrix material having embedded p-conducting semiconducting material.

10. An electronic circuit having at least one electronic component (20, 30, 300, 40, 50) as claimed in one of claims 8 or 9.

11. A process for fabricating an electronic component (20, 300, 40, 50) according to claim 1, in which process the forming of the semiconducting layers in each case includes the steps:
(a) providing an inert nonconducting matrix material, which is an organic polymer, an inorganic ceramic material or a mixture thereof, then
(b) mixing a pulverulent, inorganic semiconducting material with the inert nonconducting matrix material, then
(c) applying the mixture which contains the matrix material to the substrate material (31, 310, 41, 51), and then
(d) solidifying the matrix material, the semiconducting inorganic material being embedded in the matrix material.

12. The process as claimed in claim 11,
in which, in step (b), the pulverulent, inorganic semiconducting material is suspended in the inert nonconducting matrix material until a homogeneous suspension has formed, and
in which, in step (c), the suspension which contains the matrix material is applied to the substrate material (31, 310, 41, 51).

13. The process as claimed in claim 12, in which, in step (a), the inert nonconducting matrix material is provided in a liquid, and in which, in step (b), the pulverulent, inorganic semiconducting material is suspended in the liquid.

14. The process as claimed in claim 13, in which, in step (a), the inert nonconducting matrix material is dissolved in the liquid.

15. The process as claimed in claim 13, in which, in step (a), the inert nonconducting matrix material is suspended in the liquid.

16. The process as claimed in one of claims 14 to 15, in which the liquid is an aqueous liquid, an organic liquid, a mixture of at least two organic liquids or a mixture of aqueous and organic liquid.

17. The process as claimed in one of claims 13 to 16, in which the mixture or suspension produced in step (b) is transferred to a suitable printing or spraying device.

18. The process as claimed in one of claims 13 to 16, in which, in step (d), the liquid which contains the matrix material is removed.

19. The process as claimed in claim 18, in which the liquid is removed by means of IR irradiation and/or drying in vacuo.

20. The process as claimed in claim 19, in which the inert matrix nonconducting material is an organic polymer and is solidified by curing.

21. The process as claimed in one of claims 11 to 20, in which the inorganic semiconducting material has a particle size of between 100 4 µm and 10 nm.

22. The process as claimed in one of claims 11 to 20, in which the substrate material (31, 310, 41, 51) is selected from the group consisting of paper, plastic films, ceramics, glass, silica gel plates, also metal, plastic-coated metal, indium tin oxide, electrically conducting or electrically semiconducting substrate materials.

23. The process as claimed in one of claims 11 to 21, in which the mixture or suspension is applied to the substrate by means of a printing process.

24. The process as claimed in claim 23, in which pad printing, screen printing, stencil printing, inkjet printing, offset printing and laser printing are used as printing process.

25. A process for fabricating an electronic component according to claim 1, in which process the forming of the semiconducting layers in each case includes the steps:
(a) providing an inert nonconducting matrix material, which is an organic polymer, an inorganic ceramic material or a mixture thereof, then
(b) applying the matrix material to the substrate material (31, 310, 41, 51), and then
(c) suspending a pulverulent, inorganic semiconducting material in the inert nonconducting matrix material until a homogeneous suspension has formed, in which the semiconducting inorganic material is embedded in the matrix material.

## Revendications

1. Composant (20, 30, 300, 40, 50) électronique comprenant un matériau (31,310,41,51) de substrat et des couches (21, 22, 32, 33, 34, 320, 330, 340, 42, 43, 44, 52, 53) semi-conductrices déposées sur le matériau de substrat, le composant électronique ayant au moins une jonction semiconductrice entre deux couches (21, 22, 32, 33, 34, 320, 330, 340, 42, 43, 44, 52, 53) semi-conductrices qui ont respectivement un matériau de matrice inerte et non conducteur, dans lequel un matériau semi-conducteur minéral est incorporé sous forme de particules, **caractérisé en ce que** le matériau de matrice est un polymère organique, un matériau céramique minéral ou l'un de leurs mélanges.

2. Composant (20, 30, 300, 40, 50) électronique suivant la revendication 1, dans lequel le matériau semi-conducteur minéral est choisi dans le groupe constitué du silicium, du carbure de silicium, du germanium, de l'arséniure de gallium, du nitrure de gallium, du phosphure d'indium, du séléniure de gallium ou de leurs mélanges.

3. Composant (20, 30, 300, 40, 50) électronique suivant la revendication 1 ou 2, dans lequel le matériau semi-conducteur minéral a une dimension de particules comprise entre 100 µm et 10 nm.

4. Composant (20, 30, 300, 40, 50) électronique suivant l'une des revendications 1 à 3, dans lequel les couches (21, 22, 32, 33, 34, 320, 330, 340, 42, 43, 44, 52, 53) semi-conductrices ont une teneur en matériau semi-conducteur minéral de 20 à 90% en volume rapporté à leur volume total.

5. Composant (20, 30, 300, 40, 50) électronique suivant l'une des revendications 1 à 4, dans lequel le polymère organique est choisi dans le groupe qui est constitué de résines époxyde, d'acrylates, de polyimides, du polybenzoxazolène, du polystyrène et de polyalcoylènes.

6. Composant (20, 30, 300, 40, 50) électronique suivant l'une des revendications précédentes, dans lequel le matériau de matrice contient, en outre, un matériau organique semi-conducteur.

7. Composant (20, 30, 300, 40, 50) électronique suivant l'une des revendications précédentes, dans lequel le matériau (31, 310, 41, 51) de substrat est choisi dans le groupe qui est constitué du papier, de feuilles de matière plastique, de céramique, de verre, de lames de gel de silice, en outre de métal, de métal revêtu de matière plastique, d'oxyde d'indium et d'étain, de matériaux de substrat conducteurs de l'électricité ou semi-conducteurs du point de vue électrique.

8. Composant (20, 30, 300, 40, 50) électronique suivant l'une des revendications 1 à 7, dans lequel le composant est une diode (20, 50) ou un transistor (30, 300, 40).

9. Composant (20, 30, 300, 40, 50) électronique suivant la revendication 8, qui est un transistor (30, 300, 40), dans lequel la zone de source et la zone de drain sont en un matériau semi-conducteur pulvérulent de conductivité n dans un matériau de matrice inerte et la zone (34) de canal du transistor a un matériau de matrice inerte non conducteur ayant du matériau semi-conducteur de conductivité p qui y est incorporé.

10. Circuit électronique ayant au moins un composant (20, 30, 300, 40, 50) électronique suivant l'une des revendications 8 à 9.

11. Procédé de fabrication d'un composant (20, 30, 300, 40, 50) électronique suivant la revendication 1, dans lequel dans le procédé la formation des couches semi-conductrices comporte respectivement les stades dans lesquels :
a) on se procure un matériau de matrice non conducteur et inerte, qui est un polymère organique, un matériau céramique minéral ou l'un de leurs mélanges, puis
b) on mélange un matériau semi-conducteur minéral pulvérulent au matériau de matrice inerte et non conducteur, puis
c) on dépose le mélange contenant le matériau de matrice sur le matériau (31, 310, 41, 51) de substrat, et ensuite
d) on solidifie le matériau de matrice, le matériau minéral semi-conducteur étant incorporé dans le matériau de matrice.

12. Procédé suivant la revendication 11,
dans lequel dans le stade b) on met le matériau semi-conducteur minéral pulvérulent en suspension dans le matériau de matrice non conducteur et inerte jusqu'à formation d'une suspension homogène, et
dans le stade c) on dépose la suspension contenant le matériau de matrice sur le matériau (31, 310, 41, 51) de substrat.

13. Procédé suivant la revendication 12, dans lequel dans le stade a) on se procure le matériau de matrice non conducteur et inerte dans un liquide, et
dans lequel dans le stade b) on met le matériau semi-conducteur minéral pulvérulent en suspension dans le liquide.

14. Procédé suivant la revendication 13, dans lequel dans le stade a) on dissout le matériau de matrice non conducteur et inerte dans le liquide.

15. Procédé suivant la revendication 13, dans lequel dans le stade a) on met le matériau de matrice non conducteur et inerte en suspension dans le liquide.

16. Procédé suivant l'une des revendications 14 à 15, dans lequel le liquide est un liquide aqueux, un liquide organique, un mélange d'au moins deux liquides organiques ou un mélange de liquide aqueux et de liquide organique.

17. Procédé suivant l'une des revendications 13 à 16, dans lequel on transfert le mélange ou la suspension préparé au stade b) dans un dispositif approprié de poussée ou de pulvérisation.

18. Procédé suivant l'une des revendications 13 à 16, dans lequel dans le stade d) on élimine le liquide contenu dans le matériau de matrice.

19. Procédé suivant la revendication 18, dans lequel on élimine le liquide au moyen d'un rayonnement infrarouge et/ou par séchage sous vide.

20. Procédé suivant la revendication 19, dans lequel le matériau de matrice non conducteur et inerte est un polymère organique et il se solidifie par durcissement.

21. Procédé suivant l'une des revendications 11 à 20, dans lequel le matériau semi-conducteur minéral a une dimension de particule comprise entre 100 µm et 10 nm.

22. Procédé suivant l'une des revendications 11 à 20, dans lequel le matériau (31, 310, 41, 51) de substrat est choisi dans le groupe qui est constitué du papier, de feuilles de matière plastique, de céramique, de verre, de lames de gel de silice, en outre de métal, de métal revêtu de matière plastique, d'oxyde d'indium et d'étain, de matériaux de substrat conducteurs de l'électricité ou semi-conducteurs du point de vue électrique.

23. Procédé suivant l'une des revendications 11 à 21, dans lequel on dépose le mélange ou la suspension sur le substrat par un procédé d'impression.

24. Procédé suivant la revendication 23, dans lequel on utilise comme procédé d'impression une tampographie, une sérigraphie, une impression au pochoir, une impression au jet d'encre, une impression offset et une impression laser.

25. Procédé de fabrication d'un composant électronique suivant la revendication 1, dans lequel, dans le procédé, la formation des couches semi-conductrices comporte respectivement les stades dans lesquels :
a) on se procure un matériau de matrice non conducteur et inerte, qui est un polymère organique, un matériau céramique minéral ou l'un de leurs mélanges, puis
b) on dépose le mélange contenant le matériau de matrice sur le matériau (31, 310, 41, 51) de substrat, et ensuite
c) on met un matériau semi-conducteur minéral pulvérulent en suspension dans le matériau de matrice non conducteur et inerte jusqu'à formation d'une suspension homogène, dans laquelle le matériau minéral semi-conducteur est incorporé dans le matériau de matrice.
